Europäisches Patentamt

European Patent Office

Office européen des brevets

(11) Publication number: **0 512 701 A2**

# EUROPEAN PATENT APPLICATION

(21) Application number: **92303425.0**

(22) Date of filing: **16.04.92**

(51) Int. Cl.5: **H04B 1/38**

(30) Priority: **07.05.91 JP 101298/91**

(43) Date of publication of application:
**11.11.92 Bulletin 92/46**

(84) Designated Contracting States:
**DE FR GB**

(71) Applicant: **MATSUSHITA ELECTRIC INDUSTRIAL CO., LTD**
**1006, Oaza Kadoma, Kadoma-shi**
Osaka 571(JP)

(72) Inventor: **Sato, Yukio**
**830-1, Tokaichibacho, Midori-ku**
**Yokohama-shi(JP)**

(74) Representative: **Sorrell, Terence Gordon Fitzpatricks Europe House World Trade Center**
**London E1 9AA(GB)**

(54) Printed circuit board connecting device.

(57) A common connecting connector (2) including all of interface signals with additive function printed circuit boards (3, 4) is provided on a printed circuit board (1) of a main body, and connecting connectors (5, 6) of similar type as the common connecting connector (2) is provided on each of additive function printed circuit boards (3, 4). With this, the additive function printed circuit boards (3, 4) are connected selectively to the printed circuit board (1) of the main body.

FIG. I

EP 0 512 701 A2

Rank Xerox (UK) Business Services

## BACKGROUND OF THE INVENTION

The present invention relates to a printed circuit board connecting device for connecting one of two sheets or more of plurality of additive function printed circuit boards by replacing those boards with one another to a printed circuit board of a main body in circuit board structures of various electrical equipments.

Conventionally, a printed circuit board connecting device of this sort is provided with two or more dedicated connecting connectors on a printed circuit board of the main body so as to connect additive function printed circuit boards suitable for these dedicated connectors, respectively. Namely, when a plurality of types are connected as the additive function printed circuit boards, dedicated connectors corresponding to the number thereof are provided on the printed circuit board of the main body and desired additive function printed circuit boards are connected to relevant dedicated connectors.

Since two or more connecting connectors are provided on the printed circuit board of the main body in such a structure, however, it is not easy to realize miniaturization of the device.

## SUMMARY OF THE INVENTION

It is an object of the present invention which solves above-described subject to provide a device in which it is possible to connect one sheet of a plurality of additive function printed circuit boards having the same configuration with a printed circuit board of a main body by replacing them with one another.

In order to achieve above-described object, according to the present invention, one connecting connector including all of the interface signals with a plurality of additive function printed circuit boards is provided on a printed circuit board of the main body, so that it is made possible to connect one sheet of a plurality of additive function printed circuit boards having connecting connectors in the same configuration to the printed circuit board of the main body by replacing these boards with one another.

Thus, a common one connecting connector provided on the printed circuit board of the main body includes interface signals with a plurality of additive function printed circuit boards according to the present invention. Accordingly, such an effect is produced that it is possible to connect selectively one sheet among a plurality of additive function printed circuit boards which are not used at the same time to the printed circuit board of the main body by replacing those boards with one another optionally.

## BRIEF DESCRIPTION OF THE DRAWINGS

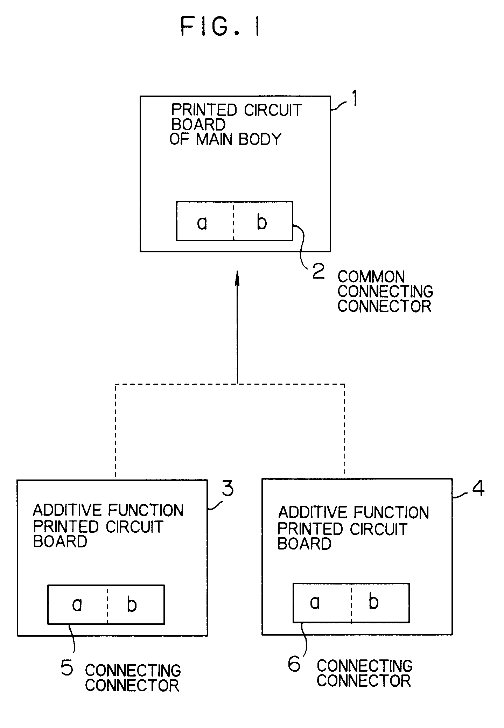

Fig. 1 is a schematic diagram showing an overall structure in an embodiment of the present invention.

## DESCRIPTION OF THE PREFERRED EMBODIMENT

Fig. 1 shows a structure of one embodiment of the present invention. In the present embodiment, the number of sheets of a plurality of additive function printed circuit boards is assumed to be two sheets including an additive function printed circuit board 3 and an additive function printed circuit board 4. A common connecting connector 2 having a group of a plurality of terminals is provided on a printed circuit board 1 of a main body, and an interface signal with the additive function printed circuit board 3 is included in a section a of the common connecting connector 2 and an interface signal with the additive function printed circuit board 4 is included in a section b thereof. The additive function printed circuit board 3 and the additive function printed circuit board 4 are printed circuit boards having the same configuration, and a connecting connector 5 and a connecting connector 6 are connectors having the same configuration connectable with the common connecting connector 2 each having a plurality of terminal groups, respectively. An interface signal with the printed circuit board 1 of the main body for the additive function circuit printed board 3 is included in a section a of the connecting connector 5, and an interface signal with the printed circuit board 1 of the main body for the additive function printed circuit board 4 is included in a section b of the connecting connector 6. Both the section b of the connecting connector 5 and the section a of the connecting connector 6 are out of use. In other words, the terminal groups (a + b) of the connector 2 of the printed circuit board 1 of the main body corresponds to the terminal groups a and b of the connecting connectors of the additive function printed circuit boards 3 and 4 in a non-duplicating manner, respectively.

As described above, according to the above-described embodiment, the printed circuit board 1 of the main body is provided with the common connecting connector 2 including interface signals with both the additive function printed circuit board 3 and the additive function printed circuit board 4. Thus, it is possible to connect one sheet of the additive function printed circuit board 3 and the additive function printed circuit board 4 both having the same configuration to the printed circuit board 1 of the main body in an alternative way by replacing them with each other.

As a concrete embodiment, the printed circuit board 1 of the main body is used as a transceiver board of a digital mobile-telephone, and respective additive function printed circuit boards 3 and 4 are used as a data terminal interface board and a functional test interface board. Thus, it is possible to keep the data terminal interface board connected to the transceiver board usually, and to remove the data terminal interface board and connect the functional test interface board so as to perform a functional test when it is desired to perform functional test of the transceiver board.

According to the present invention, a common one connecting connector provided on the printed circuit board of the main body includes all of the interface signals with the additive function printed circuit boards. Thus, it is possible to connect additive function printed circuit boards having the same configuration which are not used at the same time to the printed circuit board of the main body in an alternative way by replacing them with one another as it is apparent from the above-described embodiment. Accordingly, it is possible to aim at miniaturization of the whole device and also to maintain multifunctional performance.

**Claims**

1. A printed circuit board connecting device comprising:

    a first printed circuit board (1) having a first connecting connector (2); and

    a plurality of second printed circuit boards (3, 4) each having a second connector (5, 6) connectable with said first connecting connector (2); wherein:

    said plurality of second printed circuit boards (3, 4) are connected selectively to the first printed circuit board (1).

2. A printed circuit board connecting device comprising:

    a first printed circuit board (1) provided with a first connecting connector (2) having a plurality of connecting terminal groups (a, b); and

    a plurality of second printed circuit boards (3, 4) each having a second connector (5, 6) connectable to said first connecting connector (2), respectively; wherein:

    the connecting terminal groups (a, b) of said first connector (2) is made to correspond in a non-duplicating manner to respective terminal groups (a, b) requiring intrinsic connection with the first printed circuit board among the terminal groups of said plurality of second connecting connectors (5, 6).

3. A printed circuit board connecting device according to Claim 2, wherein the first connecting connector (2) and a plurality of second connecting connectors (5, 6) are made to include connecting terminal groups in the same number forming pairs, respectively.

4. A printed circuit board connecting device according to Claim 3, wherein one of the plurality of second printed circuit boards (5, 6) is used as a printed circuit board for an additive function of said first printed circuit board (1) and the other thereof is used as a printed circuit board for testing said additive function.

FIG. 1

PRINTED CIRCUIT
BOARD
OF MAIN BODY — 1

| a | b |

2 COMMON
CONNECTING
CONNECTOR

ADDITIVE FUNCTION
PRINTED CIRCUIT
BOARD — 3

| a | b |

5 CONNECTING
CONNECTOR

ADDITIVE FUNCTION
PRINTED CIRCUIT
BOARD — 4

| a | b |

6 CONNECTING
CONNECTOR